# FASCICULE DE BREVET EUROPEEN

(11) **EP 2 073 212 B1**
(45) Date de publication et mention de la délivrance du brevet: **11.05.2011**
(21) Numéro de dépôt: 07150366.8
(22) Date de dépôt: 21.12.2007
(51) Int. Cl.: G11C 16/28, G11C 16/32, G11C 7/08

(54) **Dispositif de lecture d'une mémoire non volatile à basse consommation, et son procédé de mise en action**
Lesevorrichtung eines nichtflüchtigen Speichers mit geringem Energieverbrauch und ihr Anwendungsverfahren
Low-consumption device for reading from a non-volatile memory, and method of activating same

(43) Date de publication de la demande: 24.06.2009
(73) Titulaire: EM Microelectronic-Marin SA, 2074 Marin (CH)
(72) Inventeur: Théoduloz, Yves, 1400 Yverdon (CH); Jaeggi, Hugo, 2046 Fontaines (CH); Harabech, Nadia, CH-2074 Marin (CH)
(74) Mandataire: Couillard, Yann Luc Raymond

(56) Documents cités:
- US-A1- 2005 169 078
- US-A1- 2005 286 323
- US-B1- 6 301 156
- M. MORRIS MANO: "Logic and Computer Design Fundamentals, 2nd Edition" 2001, PRENTICE-HALL, INC , UPPER SADDLE RIVER, NEW JERSEY 07458 , XP002477393 ISBN: 0-13-032406-X * page 119 - page 124 *

## Description

L'invention concerne un dispositif de lecture d'une mémoire non volatile à basse consommation, qui permet d'opérer une bonne supervision de chaque cycle de lecture. Le dispositif comprend un moyen d'adressage de lignes de la matrice mémoire et un moyen d'adressage de colonnes de la matrice mémoire pour la sélection de cellules mémoires à lire dans un cycle de lecture. Le dispositif de lecture comprend également des amplificateurs de détection reliés chacun à une cellule mémoire respective à lire d'une colonne sélectionnée par les moyens d'adressage de colonnes. L'ensemble des amplificateurs de détection sont activés au début d'un cycle de lecture commandé par une unité à microprocesseur, afin de fournir un mot binaire de données représentatif de la lecture des cellules mémoires sélectionnées.

L'invention concerne également un procédé de mise en action du dispositif de lecture.

Le dispositif de lecture peut servir à la supervision de lecture de tout type de mémoire non volatile, qui est composée d'une matrice de cellules mémoires. Il peut s'agir d'une mémoire par exemple EEPROM, Flash ou d'autres types de mémoires.

Généralement pour pouvoir lire une cellule mémoire non-volatile, il doit être fait une comparaison du courant de cette cellule mémoire avec un courant de référence. Cette opération est réalisée par un circuit défini comme un amplificateur de détection. Le courant de référence est généré par exemple par une cellule mémoire de référence. Celle-ci, par un agencement de miroirs de courant, génère un courant lors de chaque lecture, qui se trouve au milieu de la valeur du courant correspondant à une cellule programmée et celui d'une cellule effacée. Pour diminuer le courant de consommation, il peut être imaginé de diminuer le courant de référence injecté dans les amplificateurs de détection. Cependant un inconvénient de cette méthode, est que le temps d'accès en lecture est augmenté.

La lecture d'une mémoire non-volatile par exemple du type NOR flash consomme un courant statique aussi longtemps que l'amplificateur de détection est en fonction. Ceci constitue un autre inconvénient, car la consommation électrique d'un tel dispositif de lecture reste relativement importante surtout dans le cas où la fréquence de l'accès mémoire par une unité à microprocesseur diminue.

Dans le document de brevet US 6,301,156, il est décrit un dispositif à mémoire non volatile, telle qu'une mémoire Flash. Ce dispositif permet d'exécuter une vérification de programme basée sur un changement en courant chargé ou déchargé de condensateurs connectés à une ligne de bits d'une cellule mémoire à lire et à une ligne de bits d'une cellule de référence. Un amplificateur de détection permet de comparer les signaux de sortie du réseau de cellules mémoires avec les signaux de sortie de la cellule de référence. Cet amplificateur de détection permet de détecter ainsi une différence en potentiel de la vitesse de charge de chaque condensateur en sortie du réseau et en sortie de la cellule de référence pour déterminer un état d'une cellule mémoire sélectionnée.

Cependant la majeure partie des composants électroniques du dispositif à mémoire de ce brevet US 6,301,156 reste en fonction durant chaque cycle de vérification ou de lecture, ce qui constitue en inconvénient.

Le document de brevet US 2005/0169078 décrit par contre un dispositif de lecture d'un réseau mémoire, qui comprend des moyens pour réduire le temps de lecture durant un cycle de lecture commandé par une unité à microprocesseur. A ce titre, il comprend un moyen de temporisation de la durée de lecture dans chaque cycle de lecture initié par l'unité à microprocesseur. Le moyen de temporisation comprend un réseau mémoire factice relié à un amplificateur référence de détection, qui fournit un signal de verrouillage à un registre à verrouillage. Ce registre à verrouillage reçoit une donnée d'une cellule sélectionnée à lire à travers un amplificateur de détection. Au terme de la durée de lecture de toute donnée valide, le signal de verrouillage permet de fermer le registre à verrouillage pour conserver la donnée lue en sortie. Ce signal de verrouillage permet également de commander la déconnexion de tous les amplificateurs de détection avant une prochaine requête de lecture.

Cependant dans ce document de brevet US 2005/0169078, la durée de lecture n'est pas précisément déterminée afin de réduire le plus possible la consommation électrique, car la charge du réseau mémoire factice n'est pas bien défini.

L'invention a donc pour but de fournir un dispositif de lecture d'une mémoire susceptible de pallier aux inconvénients de l'état de la technique susmentionnés et permettant d'optimiser le temps de lecture d'une telle mémoire de manière à réduire la consommation électrique.

A cet effet, l'invention concerne un dispositif de lecture d'une mémoire cité ci-devant qui comprend les caractéristiques définies dans la revendication indépendante 1.

Des formes d'exécution particulières du dispositif de lecture sont définies dans les revendications dépendantes 2 à 7.

Un avantage du dispositif de lecture d'une mémoire réside dans le fait que même si l'unité à microprocesseur est cadencée à faible fréquence, le moyen de temporisation peut gérer indépendamment de l'unité à microprocesseur la durée effective de lecture de toutes les données valides des cellules mémoires sélectionnées.

L'invention concerne encore un procédé de mise en action du dispositif de lecture cité ci-devant qui comprend les caractéristiques définies dans la revendication indépendante 8.

Des étapes particulières du procédé de mise en action du dispositif de lecture sont définies dans les revendications dépendantes 9 à 11.

Un avantage du procédé de mise en action du dispositif de lecture réside dans le fait qu'au moment où le moyen de temporisation est mis en action suite à la commande de l'unité à microprocesseur, la durée de lecture est déterminée uniquement par le moyen de temporisation indépendamment de l'unité à microprocesseur.

Les buts, avantages et caractéristiques du dispositif de lecture d'une mémoire, et de son procédé de mise en action apparaîtront mieux dans la description suivante de manière non limitative d'au moins une forme d'exécution illustrée par les dessins sur lesquels :
la figure 1 représente une partie du dispositif de lecture selon l'invention, reliée directement aux cellules d'une mémoire non volatile,
la figure 2 représente de manière simplifiée les éléments du dispositif de lecture selon l'invention avec le moyen de temporisation pour lire une cellule mémoire sélectionnée et sauvegarder la donnée de cette cellule,
la figure 3a représente une forme d'exécution d'un amplificateur de détection du dispositif de lecture selon l'invention pour la lecture d'une cellule mémoire sélectionnée,
la figure 3b représente une forme d'exécution d'un amplificateur référence de détection relié à au moins une cellule factice et un condensateur du moyen de temporisation,
la figure 4 représente de manière simplifiée un circuit logique commandé par le moyen de temporisation pour la désactivation des amplificateurs de détection du dispositif de lecture selon l'invention, et
la figure 5 représente un graphique de l'état de certains signaux dans le temps du dispositif de lecture dans chaque cycle de lecture.

Dans la description suivante, toutes les parties du dispositif de lecture d'une mémoire, qui sont bien connues d'un homme du métier dans ce domaine technique, ne sont relatées que de manière simplifiée. La mémoire non volatile peut être de tout type, mais préférentiellement dans la description suivante, il ne sera fait référence qu'à une mémoire non volatile de type Flash.

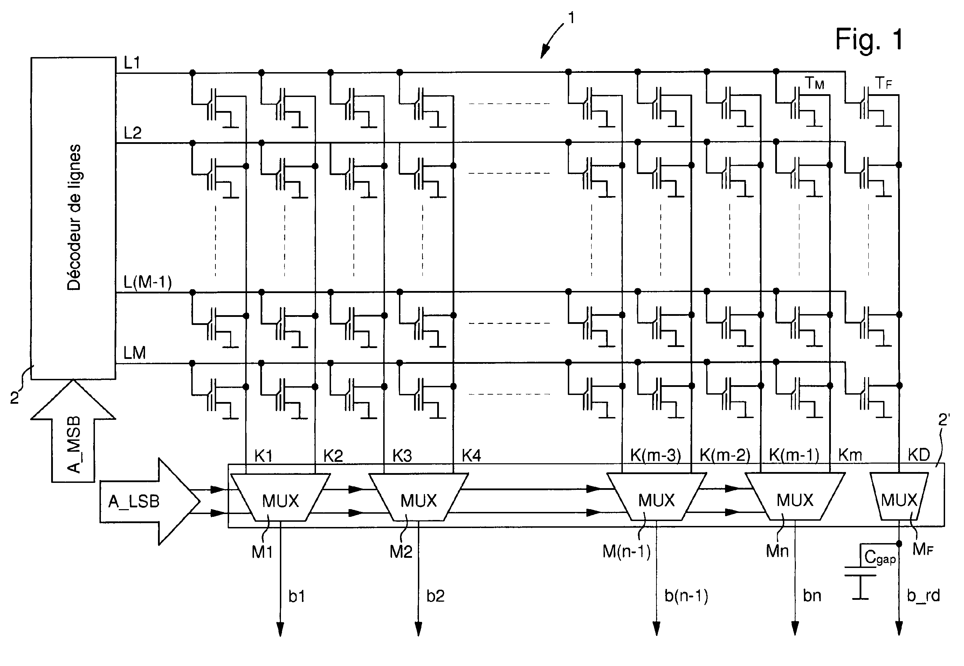

La figure 1 ne représente par mesure de clarté qu'une partie simplifiée du dispositif de lecture. Cette partie du dispositif de lecture est reliée directement à la matrice de cellules mémoires T_{M} d'une mémoire non volatile 1 du type NOR Flash pour permettre de la lire.

Le dispositif de lecture comprend un moyen d'adressage de lignes 2 et un moyen d'adressage de colonnes 2' de la matrice 1 de cellules mémoires T_{M}. Le moyen d'adressage de lignes est un décodeur de lignes 2 représenté sur la figure 1. Ce décodeur de lignes 2 reçoit un mot binaire de commande A_MSB notamment d'une unité à microprocesseur, qui peut faire partie du dispositif de lecture, pour la sélection dans un cycle de lecture d'au moins une ligne L1, L2, L(M-1), LM parmi M lignes de la matrice. Le moyen d'adressage de colonnes 2' comprend principalement n multiplexeurs M1, M2, M(n-1), Mn commandés par un mot binaire de commande A_LSB fourni par l'unité à microprocesseur non représentée. L'unité à microprocesseur fournit donc un mot binaire de commande, dont les bits de poids fort peuvent constituer le mot binaire de commande de lignes A_MSB, alors que les bits de poids faible peuvent constituer le mot binaire de commande des multiplexeurs A_LSB.

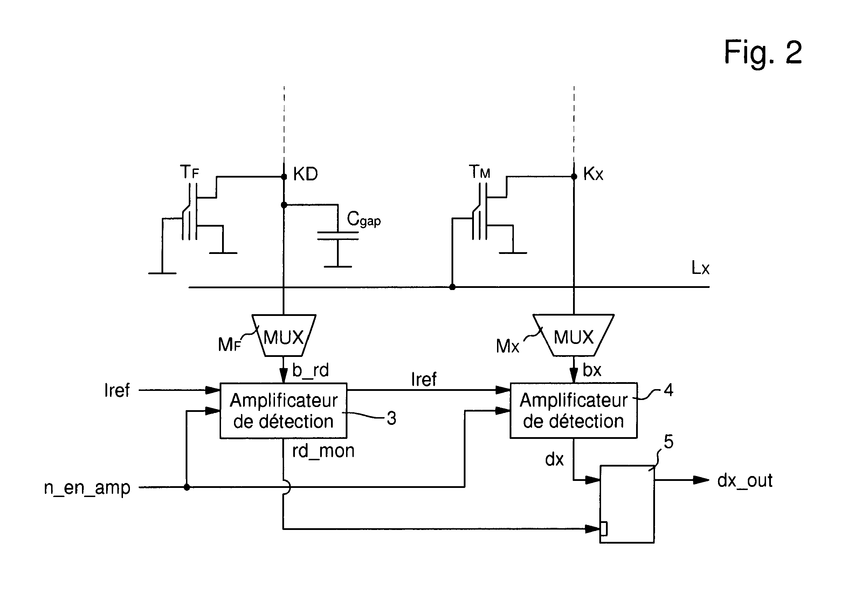

Tous les n multiplexeurs M1, M2, M(n-1), Mn sont susceptibles de fournir en sortie des signaux de données définissant n bits b1, b2, b(n-1), bn, par exemple 8 bits, relatifs à la lecture de cellules sélectionnées. Pour ce faire, plusieurs colonnes K1, K2, K3, K4, K(m-3), K(m-2), K(m-1), Km de la matrice sont reliées à chaque multiplexeur. De préférence, chaque multiplexeur est commandé par un mot binaire d'adressage A_LSB de colonnes à N bits, où N est un nombre entier plus grand ou égal à 1. Chaque multiplexeur est de ce fait relié à un nombre 2^{N} colonnes de manière à relier une de ces colonnes sélectionnée à un parmi n amplificateurs de détection expliqués ci-après en référence à la figure 2. Il peut par exemple être envisagé de relier 4 colonnes à chaque multiplexeur commandé par un mot d'adressage à 2 bits, même si par simplification il n'est représenté que 2 colonnes par multiplexeur sur la figure 1.

Le dispositif de lecture comprend également au moins une cellule factice T_{F} reliée au moyen d'adressage de colonnes 2', qui comprend une structure de multiplexeur M_{F} équivalente aux autres multiplexeurs M1 à Mn. Le multiplexeur M_{F} fournit un signal de sortie b_rd à un amplificateur référence de détection expliqué en référence à la figure 2. De préférence, il est prévu une colonne KD de cellules factices en nombre égal au nombre de cellules mémoires de chaque autre colonne. De plus, les cellules factices de cette colonne peuvent être totalement appariées aux cellules mémoires de chaque autre colonne pour définir un condensateur parasite équivalent de chaque colonne en phase de lecture.

La colonne KD de cellules factices T_{F} fait partie d'un moyen de temporisation du dispositif de lecture susceptible de définir une durée déterminée de lecture de données valides de cellules mémoires sélectionnées. Cette durée déterminée de lecture du moyen de temporisation est dépendante d'un condensateur de temporisation C_{gap} du moyen de temporisation. Ce condensateur de temporisation est relié d'une part à la colonne de cellules factices KD et d'autre part à la masse.

Sur la base de la valeur capacitive déterminée du condensateur de temporisation, la durée de lecture, dans chaque cycle de lecture initié par l'unité à microprocesseur, est définie toujours légèrement supérieure à la durée de lecture de donnée valide de n'importe quelle cellule mémoire sélectionnée. Ceci permet de réduire considérablement la consommation du dispositif de lecture en définissant la durée de lecture par le moyen de temporisation indépendamment de l'unité à microprocesseur comme expliqué ci-après en référence à la figure 2.

Chaque cellule mémoire T_{M} de la matrice 1, ainsi que chaque cellule factice T_{F} sont composées d'un transistor à grille flottante. Tous les transistors T_{M} d'une même ligne L1, L2, L(M-1), LM de la matrice mémoire ont leur grille reliée. La source de chaque transistor est connectée par exemple à la masse, alors que les drains de tous les transistors d'une même colonne K1, K2, K3, K4, K(m-3), K(m-2), K(m-1), Km de la matrice 1 sont reliés ensemble. La grille de chaque transistor factice T_{F} peut également être reliée à chaque ligne correspondante de la matrice mémoire. La source des transistors factices T_{F} est également reliée à la masse, alors que les drains de tous les transistors factices de la colonne KD sont reliés ensemble au multiplexeur M_{F}.

Le décodeur de lignes 2 peut donc sélectionner une des lignes de transistors en imposant une tension suffisante au-dessus de la masse sur chaque grille des transistors d'une même ligne. Cette tension de grille doit être supérieure à la tension de seuil du transistor pour rendre conducteur ledit transistor de la cellule mémoire dans le cas où la cellule est dans un état "1" représentant une cellule effacée. Par contre dans le cas où la cellule est dans un état "0" signe d'une cellule programmée, le transistor T_{M}, dont la grille flottante est chargée, est considéré comme non conducteur avec uniquement un faible courant de fuite le traversant en phase de lecture.

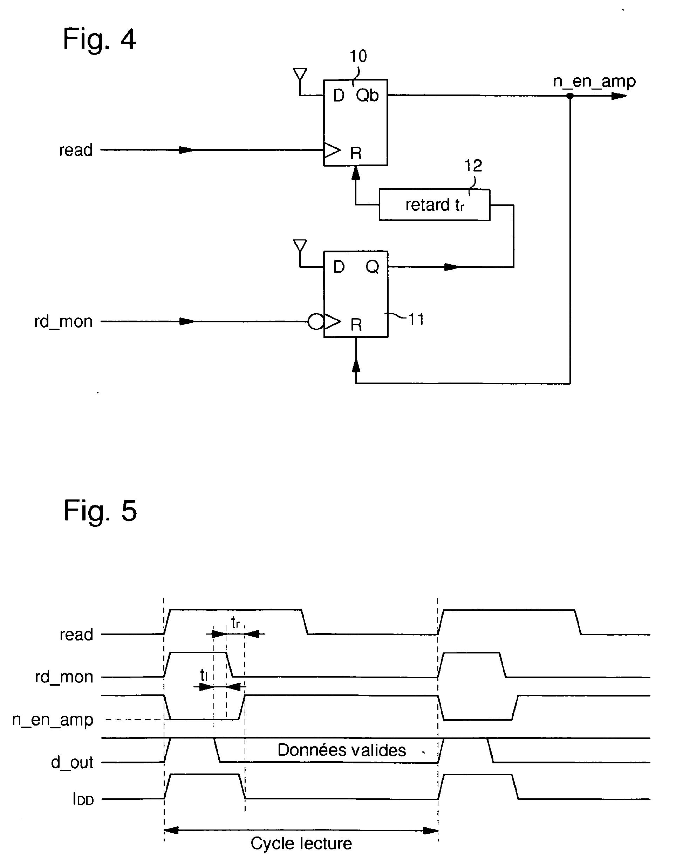

Pour comprendre le fonctionnement du dispositif de lecture avec le moyen de temporisation, il est fait référence maintenant aux éléments représentés à la figure 2 et aux graphes de certains signaux dans le temps représentés à la figure 5.

A la figure 2 par simplification, il n'est représenté qu'un transistor T_{F} d'une cellule factice faisant partie d'une colonne KD de cellules factices, et un transistor T_{M} d'une cellule mémoire sélectionnée sur une ligne Lx d'une colonne Kx sélectionnée par le multiplexeur Mx. Sur cette figure 2, il peut être envisagé de relier la grille de chaque transistor T_{F} des cellules factices directement à la masse. Chaque transistor des cellules factices doit être dans un état non conducteur pour la détermination d'une durée de lecture dans chaque cycle de lecture en combinaison du condensateur de temporisation C_{gap} relié à la masse.

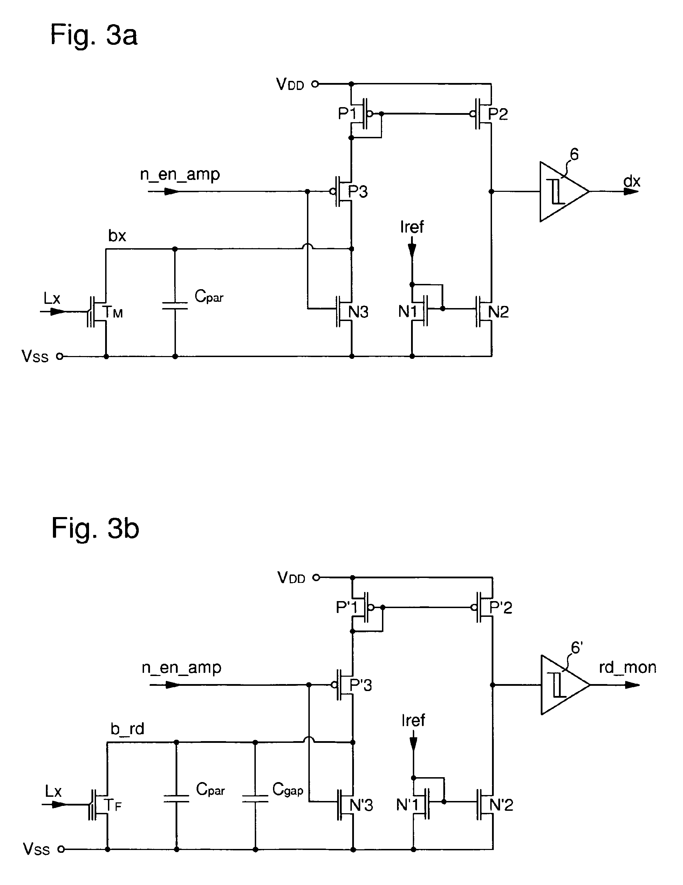

Au début de chaque cycle de lecture commandé par le flanc montant d'un signal read de l'unité à microprocesseur non représentée, tous les amplificateurs de détection 4, ainsi que l'amplificateur référence de détection 3 du moyen de temporisation sont activés par le signal de commande n_en_amp. Ce signal n_en_amp passe d'un état "1" par exemple d'une tension haute d'une source de tension d'alimentation à un état "0" proche de la masse au début de chaque cycle. Il est également fourni un courant moyen de référence Iref par une structure à miroir de courant à chaque amplificateur de détection, qui sera expliqué plus en détail ci-après en référence aux figures 3a et 3b.

Dès l'instant où les amplificateurs de détection 4 et l'amplificateur référence de détection 3 sont activés, la donnée de la cellule mémoire sélectionnée T_{M} peut être lue.

Si la cellule mémoire est programmée à l'état "0", le transistor est non conducteur et se comporte comme un condensateur parasite relié d'un côté à la masse en combinaison des autres transistors non sélectionnés de la même colonne Kx. Ce condensateur parasite est dans un état déchargé au début de chaque cycle de lecture, l'amplificateur de détection 4 une fois activé va charger le condensateur parasite au moyen d'un courant supérieur au courant moyen de référence Iref. Dans cette phase de charge, l'amplificateur de détection fournit un signal de donnée dx à l'état "1" en sortie d'un organe tampon. Après une durée de charge connue, l'amplificateur de détection 4 va fournir un signal de donnée dx passant de l'état "1" à l'état "0".

Si la cellule mémoire est effacée à l'état "1", le transistor T_{M} devient conducteur en combinaison de l'amplificateur de détection 4. Dans ce cas, l'amplificateur de détection 4 fournit pendant toute la durée de lecture un signal de donnée dx toujours à l'état "1 ".

Le moyen de temporisation du dispositif de lecture est composé d'au moins une cellule factice T_{F}, du condensateur C_{gap}, du multiplexeur M_{F} et de l'amplificateur référence de détection 3. De manière à définir un condensateur parasite équivalent à chaque colonne Kx de cellules mémoires sélectionnées, il est préférable d'avoir une colonne KD de cellules factices appariée aux autres colonnes de cellules mémoires. Le nombre de cellules factices est égal au nombre de cellules mémoires de chaque autre colonne.

L'amplificateur référence de détection 3 est relié au condensateur de temporisation C_{gap} et au transistor T_{F} de la cellule factice par l'intermédiaire du multiplexeur M_{F}. Comme le transistor factice de la cellule factice est non conducteur, il se comporte comme un condensateur parasite, qui est relié d'un côté à la masse. Ce condensateur parasite combiné en parallèle au condensateur de temporisation permet de définir une durée de lecture déterminée supérieure à la durée de lecture de toute donnée valide de chaque cellule mémoire sélectionnée.

A ce titre comme au début de chaque cycle de lecture le condensateur de temporisation et le condensateur parasite sont dans un état déchargé, l'amplificateur référence de détection 3 va fournir un courant de charge aux deux condensateurs pendant toute la durée de lecture déterminée. Pendant cette phase de charge, l'amplificateur référence de détection 3 fournit un signal de référence en sortie rd_mon, qui est à l'état "1 ". Une fois que les condensateurs sont chargés à un niveau de tension où le courant de charge devient égal au courant de référence Iref, ce signal de référence passe de l'état "1" à l'état "0" après une durée bien déterminée. Le passage de l'état "1" à l'état "0" du signal de référence rd_mon se fait après une durée tₗ au-delà de la durée maximum de lecture de toute donnée valide de n'importe quelle cellule mémoire sélectionnée. Cette durée tₗ est définie principalement par la valeur capacitive du condensateur de temporisation C_{gap}.

Ce signal de référence rd_mon permet de commander la fin de la durée de lecture indépendamment de l'unité à microprocesseur une fois que toutes les données valides des cellules mémoires sélectionnées ont pu être lues. A ce titre, le signal de référence rd_mon commande un registre à verrouillage 5, qui est dans un état ouvert pour laisser passer le signal de donnée dx et mémoriser la donnée dx_out en sortie, tant que ce signal de référence est à l'état "1 ". Une fois que le signal de référence rd_mon passe de l'état "1" à l'état "0" pour déterminer la fin de la durée de lecture, toutes les données d_out valides lues de toutes les cellules mémoires sélectionnées sont sauvegardées en sortie du registre à verrouillage 5.

Grâce à ce moyen de temporisation, cela permet à la fin de la durée de lecture de commander la désactivation de tous les amplificateurs de détection 4 et de l'amplificateur référence de détection 3 indépendamment de l'unité à microprocesseur. Même si l'unité à microprocesseur est cadencée par des signaux d'horloge à une faible fréquence, par exemple à une fréquence horlogère de l'ordre de 32 kHz, cela n'a aucune influence sur la durée de lecture définie par le moyen de temporisation dans chaque cycle de lecture. Ceci permet de réduire considérablement la consommation du dispositif de lecture en phase de lecture. De plus même si l'unité à microprocesseur est cadencée par des signaux d'horloge à haute fréquence par exemple de l'ordre de 5 MHz, chaque nouveau cycle de lecture ne pourra pas débuter tant que la durée de lecture déterminée par le moyen de temporisation n'est pas terminée.

Aux figures 3a et 3b, il est représenté d'une part une forme d'exécution d'un amplificateur de détection connecté à un transistor T_{M} d'une cellule mémoire à lire, et d'autre part une forme d'exécution de l'amplificateur référence de détection de structure identique connecté à un transistor T_{F} d'une cellule factice. Par mesure de simplification, il n'est pas représenté le multiplexeur intercalé entre chaque amplificateur et la cellule mémoire ou factice.

A la figure 3a, l'amplificateur de détection comprend un premier miroir de courant N1 et N2 pour miroiter le courant de référence Iref dans une branche de comparaison. Ce premier miroir de courant est composé de transistors du type NMOS. Le premier transistor NMOS N1 a sa borne de source reliée à la masse V_{SS} et ses bornes de grille et drain reliées ensemble pour recevoir le courant de référence Iref. Le second transistor NMOS N2 est relié par sa borne de grille à la borne de grille du premier transistor, et sa borne de source reliée à la masse V_{SS}. Le courant Iref est normalement miroité pour passer entre la borne de drain et la borne de source dans ce second transistor N2.

L'amplificateur de détection comprend également un second miroir de courant constitué de deux transistors du type PMOS P1 et P2. Le premier transistor PMOS P1 a sa borne de source reliée à la borne de tension haute V_{DD} d'une source de tension d'alimentation, qui peut être une tension régulée également. Les bornes de grille et drain du premier transistor PMOS P1 sont reliées ensemble pour la génération d'un courant à miroiter dans le second transistor PMOS P2. Ce second transistor PMOS P2 a sa borne de source reliée à la borne de tension haute V_{DD}, et sa borne de grille reliée à la borne de grille du premier transistor PMOS P1. La borne de drain du second transistor PMOS P2 est reliée à la borne de drain du second transistor NMOS N2 pour définir une branche de comparaison de courant.

Le noeud de connexion des transistors PMOS P2 et NMOS N2 est relié à un organe tampon 6 pour fournir en sortie un signal de donnée dx. Cet organe tampon 6 peut être un déclencheur bistable (Schmitt Trigger en terminologie anglaise) bien connu.

L'amplificateur de détection comprend encore un étage inverseur composé du troisième transistor PMOS P3 et du troisième transistor NMOS N3 monté en série. Les bornes de grille des troisièmes transistors P3 et N3 sont reliées ensemble pour recevoir le signal de commande n_en_amp pour l'activation ou la désactivation de l'amplificateur de détection. La borne de source du troisième transistor PMOS P3 est reliée directement aux bornes de grille et drain du premier transistor PMOS P1. La borne de source du troisième transistor NMOS N3 est par contre reliée directement à la masse V_{SS}. Le noeud de connexion des deux bornes de drain des troisièmes transistors P3 et N3 est reliée à une cellule mémoire T_{M} sélectionnée à lire.

Cette cellule mémoire peut être un transistor à grille flottante traditionnel T_{M}, dont la borne de source est reliée à la masse et la borne de drain est reliée au noeud de connexion des troisièmes transistors. Un condensateur parasite Cₚₐᵣ est représenté en parallèle de ce transistor relatif à l'ensemble des éléments de la colonne mémoire sélectionnée. Ce transistor à grille flottante est commandé sur sa grille par une tension de sélection de ligne Lx.

Dans le cas où la cellule mémoire est effacée dans un état "1", le transistor à grille flottante est conducteur. Au début d'un cycle de lecture, le signal de commande n_en_amp passe d'un état "1" à un état "0" proche de la masse V_{SS}, ce qui fait que le troisième transistor PMOS P3 devient conducteur pour relier le premier transistor PMOS P1 à la cellule mémoire sélectionnée. Comme le transistor à grille flottante T_{M} de la cellule mémoire est conducteur, un courant est généré entre le premier transistor PMOS P1 et le transistor à grille flottante de valeur bien définie. Ce courant généré peut ainsi être miroité par le premier transistor PMOS P1 dans le second transistor PMOS P2. Ce courant miroité dans le second miroir de courant est supérieur au courant de référence Iref, ce qui fait que le noeud de connexion des seconds transistors P2 et N2 est à l'état haut "1" pour représenter la donnée dx à l'état "1" représentatif de la donnée lue de la cellule mémoire. La valeur du courant de référence Iref peut être définie la moitié de la valeur du courant miroité pour une cellule mémoire effacée lue.

Dans le cas où la cellule mémoire est programmée dans un état "0", le transistor à grille flottante est non conducteur. Comme le signal de commande n_en_amp avant le début du cycle de lecture est à l'état "1", le troisième transistor NMOS N3 décharge complètement le condensateur parasite Cₚₐᵣ. De ce fait pour une telle cellule mémoire programmée, au début du cycle de lecture, un courant de charge est généré par le premier transistor PMOS P1 relié au condensateur parasite Cₚₐᵣ. Ce courant de charge est au début supérieur au courant de référence Iref. Ceci a pour conséquence que pendant une certaine durée de lecture de la donnée, la donnée en sortie de l'amplificateur de détection est tout d'abord à l'état "1 ". Cette donnée passe à l'état "0" en sortie comme donnée valide quand le condensateur parasite s'est suffisamment chargé à un niveau de tension où le courant miroité dans le second transistor PMOS P2 devient inférieur au courant de référence Iref.

On comprend donc que lorsque la valeur du condensateur parasite est importante, la durée de lecture nécessaire pour obtenir une donnée valide en sortie de l'amplificateur de détection est relativement longue. De ce fait, il est nécessaire de prévoir un moyen de temporisation pour définir une durée totale de lecture de toutes les cellules mémoires sélectionnées légèrement plus grande que la durée maximale de lecture de ces cellules dans le pire des cas.

A la figure 3b, l'amplificateur référence de détection du moyen de temporisation est de structure totalement identique à l'amplificateur de détection expliqué en référence à la figure 3a. Cet amplificateur référence de détection comprend donc un premier miroir de courant constitué par deux transistors NMOS N'1 et N'2, un second miroir de courant constitué par deux transistors PMOS P'1 et P'2, et un étage inverseur constitué de deux troisièmes transistors PMOS P'3 et NMOS N'3. Comme tous ces éléments sont branchés de la même manière que les mêmes éléments de l'amplificateur de détection expliqués en référence à la figure 3a, ils ne seront donc pas expliqués.

Bien entendu il peut être imaginé de concevoir un même premier miroir de courant avec plusieurs seconds transistors NMOS reliés à un seul premier transistor NMOS N1 ou N'1, qui reçoit un courant de référence Iref à miroiter dans tous les seconds transistors NMOS.

La différence essentielle de cet amplificateur référence de détection est qu'il est adapté pour être relié à une cellule factice T_{F}, qui fournit le signal b_rd, avec un condensateur parasite Cₚₐᵣ associé disposé en parallèle, et à un condensateur de temporisation C_{gap} connecté en parallèle du condensateur parasite. Comme la cellule factice est dans un état non conducteur en phase de lecture, une charge des deux condensateurs, initialement déchargés par le troisième transistor NMOS N'3, doit être opérée depuis le début du cycle de lecture. Le signal de référence rd_mon, fourni en sortie de l'organe tampon 6', est donc à l'état "1" pendant toute la durée de temporisation définie principalement par la combinaison du condensateur parasite et du condensateur de temporisation. Dès que les condensateurs sont suffisamment chargés à un niveau de tension où le courant miroité dans le second transistor PMOS P'2 devient inférieur au courant de référence Iref miroité dans le second transistor NMOS N'2, le signal de référence rd_mon passe à l'état "0".

Le passage de l'état "1" à l'état "0" du signal de référence rd_mon détermine la fin de la durée de lecture de toutes les données valides des cellules mémoires sélectionnées. Comme le condensateur parasite Cₚₐᵣ de la colonne de cellules factices est de valeur proche de la valeur capacitive d'un condensateur parasite d'une colonne mémoire sélectionnée, il est possible de bien définir la durée supplémentaire pour la lecture de toutes les données valides à l'aide du condensateur de temporisation C_{gap}.

Normalement au passage de l'état "1" à l'état "0" du signal de référence rd_mon, tous les amplificateurs de détection, ainsi que l'amplificateur référence de détection doivent être désactivés. Cependant pour s'assurer que toutes les données fournies dans le registre à verrouillage expliqué en référence à la figure 2, sont bien mémorisées dans ce registre, un retard de désactivation desdits amplificateurs doit être défini. La figure 4 représente un circuit logique permettant de fournir un signal de commande n_en_amp dont l'état change après un certain retard tᵣ suivant la fin de la durée de lecture définie par le signal de référence rd_mon.

Le circuit logique comprend une première bascule de type D 10, une seconde bascule de type D 11 et une porte à retard 12 disposée entre la sortie Q de la seconde bascule 11 et une entrée de remise à zéro R de la première bascule 10. Chaque entrée D des deux bascules 10 et 11 est placée à l'état "1", c'est-à-dire à une tension haute d'une source de tension d'alimentation par exemple.

Au début de chaque cycle de lecture comme montré également à la figure 5, le signal read est fourni par l'unité à microprocesseur qui commande le début de chaque cycle de lecture. Le flanc montant de ce signal read permet de commander la première bascule 10 afin que la sortie inversée Qb passe de l'état "1" à l'état "0", ce qui fait passer à l'état "0" le signal de commande n_en_amp initialement à l'état "1". La sortie de la seconde bascule au début du cycle de lecture reste à l'état "0" sans changement car le signal de référence rd_mon est fourni à une entrée de commande inversée de la seconde bascule 11. Le signal de référence rd_mon passe de l'état "0" à l'état "1" au début du cycle de lecture, ce qui n'impose aucun changement à la sortie Q de la seconde bascule.

Au terme de la durée de lecture déterminée par la moyen de temporisation, le signal de référence rd_mon va passer de l'état "1" à l'état "0", ce qui va commander à l'entrée inversée de commande de la seconde bascule un changement du signal de sortie Q. Ce changement d'état de la sortie Q de la seconde bascule, qui constitue un flanc montant, n'est fourni à l'entrée de remise à zéro R de la première bascule 10 qu'après un retard tᵣ défini par une porte à retard 12 bien connue. Le flanc montant du signal retardé fourni à l'entrée de remise à zéro R de la première bascule a pour conséquence de faire passer le signal de commande n_en_amp de l'état "0" à l'état "1" dans lequel les amplificateurs de détection et l'amplificateur référence de détection sont désactivés. Le passage de l'état "0" à l'état "1" de ce signal de commande n_en_amp permet de commander à l'entrée de remise à zéro R de la seconde bascule 11, le passage de la sortie Q de l'état "1" à l'état "0" dans l'attente d'une nouveau cycle de lecture.

Une fois que les amplificateurs de détection et l'amplificateur référence de détection sont désactivés, le courant I_{DD} du dispositif de lecture est montré à la figure 5 fortement diminué. Il peut être aussi imaginé de prévoir de couper la source de courant de référence Iref non représentée au terme de chaque durée de lecture. C'est un avantage important du dispositif de lecture, car dans le cas où l'unité à microprocesseur est cadencée par un signal d'horloge à basse fréquence, chaque cycle de lecture est relativement long. De ce fait, le moyen de temporisation du dispositif de lecture permet de définir une durée de lecture bien inférieure à la durée de chaque cycle de lecture.

Tous les éléments décrits ci-devant peuvent être intégrés sur une même puce réalisée dans une technologique CMOS habituelle. Le dispositif de lecture peut être alimenté par une source de tension d'alimentation à une tension comprise entre 2 et 5.5 V.

A partir de la description qui vient d'être faite, plusieurs variantes de réalisation du dispositif de lecture et de son procédé de mise en action peuvent être conçues par l'homme du métier sans sortir du cadre de l'invention définie par les revendications. Il peut être envisagé un autre moyen de temporisation avec plusieurs condensateurs programmables en fonction de la durée de lecture escomptée. La programmation du réseau de condensateurs de temporisation peut être effectué sur commande de l'unité à microprocesseur. Il peut être également imaginé un moyen de temporisation sous la forme d'un monoflop.

## Revendications

1. Dispositif de lecture d'une mémoire non volatile (1), qui est composée d'une matrice de cellules mémoires (T_{M}), le dispositif comprenant un moyen d'adressage de lignes (Lx) de la matrice mémoire pour sélectionner au moins une ligne de cellules mémoires, un moyen d'adressage de colonnes (Kx) de la matrice mémoire pour sélectionner des colonnes pour la lecture de cellules mémoires des colonnes sélectionnées sur une ligne mémoire sélectionnée dans un cycle de lecture commandé par une unité à microprocesseur, des amplificateurs de détection (4) reliés chacun à une cellule mémoire respective à lire d'une colonne sélectionnée par les moyens d'adressage de colonnes, l'ensemble des amplificateurs de détection, qui sont activés au début d'un cycle de lecture par l'unité à microprocesseur, fournissant un mot binaire de données représentatif de la lecture des cellules mémoires sélectionnées, et un moyen de temporisation (3, M_{F}, T_{F}, C_{gap}) activé au début de chaque cycle de lecture pour fournir un signal de référence (rd_mon) commandant la durée de lecture des cellules sélectionnées indépendamment de l'unité à microprocesseur, cette durée de lecture étant déterminée suffisante pour la lecture de toutes les données valides des cellules mémoires sélectionnées dans chaque cycle de lecture,
**caractérisé en ce que** le moyen de temporisation comprend une colonne de cellules factices de référence (T_{F}), qui sont programmées et appariées aux cellules mémoires de chaque colonne de la mémoire non volatile, la colonne de cellules factices étant reliée par l'intermédiaire du moyen d'adressage de colonnes à un amplificateur référence de détection (3), qui fournit le signal de référence (rd_mon), et un condensateur de temporisation (C_{gap}) relié à la colonne de cellules factices programmées non conductrices, qui définit un condensateur parasite combiné au condensateur de temporisation de valeur capacitive déterminée, pour définir la durée de lecture souhaitée.

2. Dispositif de lecture selon la revendication 1, **caractérisé en ce que** le moyen de temporisation comprend un réseau de condensateurs de temporisation programmé sur commande de l'unité à microprocesseur.

3. Dispositif de lecture selon la revendication 1, **caractérisé en ce que** l'amplificateur de référence de détection fournit un signal de référence, qui est dans un premier état au début de chaque cycle de lecture commandé par l'unité à microprocesseur, lorsque le condensateur de temporisation combiné à un condensateur parasité lié à la cellule factice est en phase de charge, et dans un second état dès que le condensateur de temporisation combiné au condensateur parasite sont chargés après un laps de temps déterminé, le passage du premier état au second état du signal de référence commandant la fin de la durée de lecture de chaque cycle de lecture.

4. Dispositif de lecture selon l'une des revendications précédentes, **caractérisé en ce que** le signal de référence commande la mise en mémoire dans un registre à verrouillage (5) des données valides des cellules mémoires sélectionnées.

5. Dispositif de lecture selon la revendication 3, **caractérisé en ce que** les amplificateurs de détection sont désactivés par un signal de sortie (n_en_amp) d'un circuit logique (10, 11, 12) suite au passage du premier état au second état du signal de référence fourni en entrée du circuit logique.

6. Dispositif de lecture selon la revendication 5, **caractérisé en ce que** le circuit logique comprend une première bascule de type D (10) fournissant le signal de sortie du circuit logique, une seconde bascule de type D (11) et une porte à retard (12) disposée entre la sortie de la seconde bascule commandée par le signal de référence (rd_mon) et une entrée de mise à zéro (R) de la première bascule commandée par un signal (read) de début de cycle de lecture fourni par une unité à microprocesseur, la porte à retard permettant de retarder la désactivation des amplificateurs de détection suite au changement d'état du signal de référence.

7. Dispositif de lecture selon la revendication 1, **caractérisé en ce que** le moyen d'adressage de colonnes comprend un nombre de multiplexeurs équivalent au nombre d'amplificateurs de détection, chaque multiplexeur étant commandé par un mot binaire d'adressage de colonnes à N bits, où N est un nombre entier plus grand ou égal à 1, et relié chacun à un nombre 2^{N} colonnes de manière à relier une de ces colonnes à un amplificateur de détection respectif en fonction du mot binaire d'adressage pour la lecture des cellules mémoires sélectionnées.

8. Procédé de mise en action d'un dispositif de lecture d'une mémoire non volatile (1) selon l'une des revendications précédentes, pour lequel le moyen de temporisation comprend une colonne de cellules factices (T_{F}) programmées et appariées aux cellules mémoires de chaque colonne de la mémoire non volatile, la colonne de cellules factices définissant un condensateur parasite (Cₚₐᵣ) combiné à un condensateur de temporisation (C_{gap}) pour définir la durée de lecture souhaitée, la colonne de cellules factices étant reliée à un amplificateur référence de détection (3), qui fournit le signal de référence (rd_mon), **caractérisé en ce qu'**il comprend pour chaque cycle de lecture commandé par une unité à microprocesseur, les étapes consistant à :
- au début de chaque cycle de lecture, activer chaque amplificateur de détection (4) par un signal de début de cycle (read) fourni par l'unité à microprocesseur, sélectionner une ligne et des colonnes de cellules mémoires à lire, chaque colonne sélectionnée étant reliée à un amplificateur de détection respectif, et activer le moyen de temporisation,
- lire les données des cellules mémoires sélectionnées par l'intermédiaire des amplificateurs de détection activés pour fournir un mot binaire de données des cellules mémoires sélectionnées,
- commander la fin de la durée de lecture dans le cycle de lecture par un signal de référence fourni par le moyen de temporisation indépendamment de l'unité à microprocesseur, ladite durée de lecture étant déterminée suffisante en fonction du condensateur de temporisation (C_{gap}) pour la lecture de toutes les données valides des cellules mémoires sélectionnées dans chaque cycle de lecture.

9. Procédé selon la revendication 8, **caractérisé en ce que** chaque amplificateur de détection est désactivé à la fin de la durée de lecture sur la base du signal de référence (rd_mon), ledit signal de référence passant d'un premier état pendant la durée de lecture où le condensateur parasite et le condensateur de temporisation sont en phase de charge au moyen d'un courant fourni par l'amplificateur référence de détection, à un second état dans lequel les condensateurs sont chargés.

10. Procédé selon l'une des revendications 8 et 9, **caractérisé en ce que** pendant la durée de lecture, le signal de référence commande la mise en mémoire dans un registre à verrouillage (5) des données valides des cellules mémoires sélectionnées.

11. Procédé selon l'une des revendications 8 à 10, **caractérisé en ce que** les amplificateurs de détection sont désactivés par un signal de sortie (n_en_amp) d'un circuit logique (10, 11, 12) suite au passage du premier état au second état du signal de référence fourni en entrée du circuit logique, ledit circuit logique comprenant une porte à retard pour retarder la désactivation des amplificateurs de détection suite au changement d'état du signal de référence.

## Claims

1. Device for reading a non-volatile memory (1), which consists of a matrix of memory cells (T_{M}), said device including means for addressing rows (Lₓ) of the memory matrix to select at least one row of memory cells, means for addressing columns (Kx) of the memory matrix to select columns for reading memory cells of the columns selected on a selected memory row in a read cycle controlled by a microprocessor unit, sense amplifiers (4), each connected to a respective memory cell for reading a column selected by the column addressing means, wherein all the sense amplifiers that are activated at the beginning of a read cycle by the microprocessor unit supply a binary data word representing the reading of the selected memory cells, and time-lag means (3, M_{F}, T_{F}, C_{gap}) activated at the beginning of each read cycle to supply a reference signal (rd_mon) to control the read time of cells selected independently of the microprocessor unit, wherein this read time is determined to be sufficient to read all the valid data of the selected memory cells in each read cycle,
**characterised in that** the time-lag means include a column of dummy reference cells (T_{F}) that are programmed and matched to the memory cells of each column of the non volatile memory, the column of dummy cells being connected by means of the column addressing means to a reference sense amplifier (3), which supplies the reference signal (rd_mon), and a time-lag capacitor (C_{gap}) connected to the column of dummy cells programmed to be non-conductive, which defines a parasitic capacitor combined with the time-lag capacitor having a determined capacitance to define the desired read time.

2. Reading device according to claim 1, **characterised in that** the time-lag means include a network of time-lag capacitors programmed under control of the microprocessor unit.

3. Reading device according to claim 1, **characterised in that** the reference sense amplifier supplies a reference signal, which is in a first state at the beginning of each read cycle controlled by the microprocessor unit when the time-lag capacitor connected with the parasitic capacitor linked to the dummy cell is in charge phase, and in a second state as soon as the time-lag capacitor in association with the parasitic capacitor are charged after a determined time lapse, wherein the shift from the first state to the second state of the reference signal controls the end of the read time of each read cycle.

4. Reading device according to one of the preceding claims, **characterised in that** the reference signal controls the storage in a latch register (5) of the valid data of the selected memory cells.

5. Reading device according to claim 3, **characterised in that** the sense amplifiers are deactivated by an output signal (n_en_amp) of a logic circuit (10, 11, 12) following the shift from the first state to the second state of the reference signal supplied in input from the logic circuit.

6. Reading device according to claim 5, **characterised in that** the logic circuit comprises a first D type flip-flop (10) supplying the output signal of the logic circuit, a second D type flip-flop (11) and a delay circuit (12) arranged between the output of the second flip-flop controlled by the reference signal (rd_mon) and a zero reset input (R) of the first flip-flop controlled by a read cycle start signal (read) supplied by a microprocessor unit, wherein the delay circuit allows the deactivation of the sense amplifiers to be delayed following the change in state of the reference signal.

7. Reading device according to claim 1, **characterised in that** the column addressing means comprises a number of multiplexers equivalent to the number of sense amplifiers, wherein each multiplexer is controller by a binary word for addressing columns of N bits, wherein N is an integer greater than or equal to 1, and each being linked to a column number 2^{N} in order to link one of these columns to a respective operating sense amplifier dependent on the binary word of address for reading the selected memory cells.

8. Method for implementing a device for reading a non-volatile memory (1) according to one of the preceding claims, in which the time-lag means comprise a column of dummy cells (T_{F}) that are programmed and matched to the memory cells of each column of the non-volatile memory, wherein the column of dummy cells defines a parasitic capacitor (Cₚₐᵣ) combined with a time-lag capacitor (C_{gap}) to define the desired read time, and the column of dummy cells is linked to a reference sense amplifier (3), which supplies the reference signal (rd_mon), **characterised in that** for each read cycle controlled by a microprocessor unit it comprises the following steps:
- activating each sense amplifier (4) at the start of each read cycle by a cycle start signal (read) supplied by the microprocessor unit, selecting a row and columns of memory cells to be read, wherein each selected column is linked to a respective sense amplifier, and activating the time-lag means,
- reading the data of the selected memory cells by means of the sense amplifiers to supply a binary data word of the selected memory cells,
- controlling the end of the read time in the read cycle by a reference signal supplied by the time lag means independently of the microprocessor unit, wherein said read time is determined so that it is sufficient to read all the valid data of the selected memory cells in each read cycle.

9. Method according to claim 8, **characterised in that** each sense amplifier is deactivated at the end of the read time on the basis of the reference signal (rd_mon), wherein said reference signal shifts from a first state during the read time, in which the parasitic capacitor and the time-lag capacitor are in charge phase by means of a current supplied by the reference sense amplifier, to a second state in which the capacitors are charged.

10. Method according to one of claims 8 and 9, **characterised in that** during the read time the reference signal controls the storage in a latch register (5) of the valid data of the selected memory cells.

11. Method according to one of claims 8 to 10, **characterised in that** the sense amplifiers are deactivated by an output signal (n_en_amp) of a logic circuit (10, 11, 12) following the shift from the first state to the second state of the reference signal supplied in input from the logic circuit, wherein said logic circuit has a delay circuit to delay the deactivation of the sense amplifiers following the change of state of the reference signal.

## Patentansprüche

1. Vorrichtung zum Lesen eines nichtfilüchtigen Speichers (1), der aus einer Speicherzellenmatrix (T_{M}) ausgebaut ist, wobei die Vorrichtung ein Mittel (Lx) für die Adressierung von Zeilen der Speichermatrix, um wenigstens eine Zeile von Speicherzellen auszuwählen, ein Mittel (Kx) für die Adressierung von Spalten der Speichermatrix, um Spalten auszuwählen, um Speicherzellen ausgewählter Spalten in der ausgewählten Speicherzeile in einem von einer Mikroprozessoreinheit befohlenen Lesezyklus zu lesen, Detektionsverstärker (4), die jeweils mit einer entsprechenden zu lesenden Speicherzelle einer durch die Spaltenadressierungsmittel ausgewählten Spalte verbunden sind, wobei die Gesamtheit der Detektionsverstärker, die am Anfang eines Lesezyklus von der Mikroprozessoreinheit aktiviert werden, ein binäres Datenwort liefert, das das Leseergebnis der ausgewählten Speicherzellen repräsentiert, und ein Zeitgebungsrmittel (3, M_{F}, T_{F}, C_{gap}), das am Beginn jedes Lesezyklus aktiviert wird, um ein Referenzsignal (rd_mon) zu liefern, das die Lesedauer der ausgewählten Zellen unabhängig von der Mikroprozessoreinheit steuert, umfasst, wobei diese Lesedauer ausreichend groß bestimmt ist, um sämtliche gültigen Daten ausgewählter Speicherzellen in jedem Lesezyklus zu lesen,
**dadurch gekennzeichnet, dass** das Zeitgebungsmittel eine Spalte von Referenz-Scheinzellen (T_{F}), die programmiert und mit den Speicherzellen jeder Spalte des nichtflüchtigen Speichers gepaart sind, wobei die Spalte von Scheinzellen über das Spaitenadressierungsmittel mit einem Referenz-Detektionsverstärker (3) verbunden ist, der das Referenzsignal (rd_mon) liefert, und einen Zeitgebungskondensator (C_{gap}), der mit der Spalte nicht durchschaltender programmierter Scheinzellen verbunden ist, die einen parasitären Konden-sator definiert, der mit dem Zeitgebungskondensator mit bestimmten kapazitiven Wert kombiniert ist, um die gewünschte Lesedauer zu definieren, umfasst.

2. Lesevorrichtung nach Anspruch 1, **dadurch gekennzeichnet, dass** das Zeitgebungsmittel ein Netzwerk von Zeitgebungskondensatoren umfasst, das auf Befehl der Mikroprozessoreinheit programmiert wird.

3. Lesevorrichtung nach Anspruch 1, **dadurch gekennzeichnet, dass** der Referenz-Detektionsverstärker ein Referenzsignal liefert, das am Beginn jedes Lesezyklus, der durch die Mikroprozessoreinheit befohlen wird, in einem ersten Zustand ist, wenn der Zeitgebungskondensator, der mit einem parasitären Kondensator kombiniert ist, der mit der Scheinzelle verbunden ist, in der Ladephase ist, und in einem zweiten Zustand ist, sobald der mit dem parasitären Kondensator kombinierte Zeitgebungskondensator nach einer bestimmten Zeitverzögerung geladen wird, wobei der Übergang des Referenzsignals vom ersten Zustand in den zweiten Zustand das Ende der Lesedauer jedes Lesezyklus befiehlt.

4. Lesevorrichtung nach einem der vorhergehenden Ansprüche, **dadurch gekennzeichnet, dass** das Referenzsignal das Speichern gültiger Daten der ausgewählten Speicherzellen in einem Sperrregister (5) befiehlt.

5. Lesevorrichtung nach Anspruch 3, **dadurch gekennzeichnet, dass** die Detektionsverstärker durch ein Ausgangssignal (n_en_amp) einer Logikschaltung (10, 11, 12) nach dem Übergang vom ersten Zustand in den zweiten Zustand des an den Eingang der Logikschaltung gelieferten Referenzsignals deaktiviert werden.

6. Lesevorrichtung nach Anspruch 5, **dadurch gekennzeichnet, dass** die Logikschaltung ein erste Kippschaltung des Typs D (10), die das Ausgangssignal der Logikschaltung liefert, eine zweite Kippschaltung des Typs D (11) und ein Zeitverzögerungsgatter (12), das zwischen dem Ausgang der durch das Referenzsignal (rd_mon) gesteuerten zweiten Kippschaltung und einem Nullrücksetz-eingang (R) der ersten Kippschaltung, die durch ein Lesezyklusanfangssignal (read), das von einer Mikroprozessoreinheit geliefert wird, gesteuert wird, angeordnet ist, umfasst, wobei das Zeitverzögerungsgatter ermöglicht, die Deaktivierung der Detektionsverstärker nach der Änderung des Zustands des Referenz-signals zu verzögern.

7. Lesevorrichtung nach Anspruch 1, **dadurch gekennzeichnet, dass** das Spaltenadressierungsmittel eine Anzahl von Multiplexern umfasst, die zu der Anzahl von Detektionsverstärkern äquivalent ist, wobei jeder Multiplexer durch ein Spaitenadressierungsbinärwort mit N Bits gesteuert wird, wobei N eine ganze Zahl größer oder gleich 1 ist, und jeweils mit einer Anzahl 2^{N} von Spalten verbunden ist, derart, dass eine dieser Spalten gemäß dem Adressierungsbinärwort mit einem jeweiligen Detektionsverstärker verbunden ist, um die ausgewählten Speicherzellen zu lesen.

8. Verfahren zum Betreiben einer Lesevorrichtung eines nichtflüchtigen Speichers (1) nach einem der vorhergehenden Ansprüche, wobei das Zeitgebungsmittel eine Spalte von Scheinzellen (T_{F}) umfasst, die programmiert und mit den Speicherzellen jeder Spalte des nichtflüchtigen Speichers gepaart sind, wobei die Spalte von Scheinzellen einen parasitären Kondensator (Cpₐᵣ) definiert, der mit einem Zeitgebungskondensator (C_{gap}) kombiniert ist, um die gewünschte Lesedauer zu definieren, wobei die Spalte von Scheinzellen mit einem Referenz-Detektionsverstärker (3) verbunden ist, der das Referenzsignal (rd_mon) liefert, **dadurch gekennzeichnet, dass** es für jeden durch eine Mikroprozessoreinheit gesteuerten Lesezyklus die Schritte umfasst, die darin bestehen:
- am Beginn jedes Lesezyklus jeden Detektionsverstärker (4) durch ein Zyklusanfangssignal (read), das von der Mikroprozessoreinheit geliefert wird, zu aktivieren, eine Zeile und Spalten von zu lesenden Speicherzellen auszuwählen, wobei jede ausgewählte Spalte mit einem jeweiligen Detektionsverstärker verbunden ist, und das Zeitgebungsmittel zu aktivieren,
- die Daten der ausgewählte Speicherzellen über die aktivierten De tektionsverstärker zu lesen, um ein binäres Datenwort der ausgewählten Speicherzellen zu liefern,
- das Ende der Lesedauer in einem Lesezyklus durch ein Referenzsignal zu befehlen, das von dem Zeitgebungsmittel unabhängig von dem Mikroprozessor geliefert wird, wobei die Lesedauer als Funktion des Zeitgebungskondensators (C_{gap}) ausreichend lang bestimmt wird, um sämtliche gültige Daten der ausgewählten Speicherzellen in jedem Lesezyklus zu lesen.

9. Verfahren nach Anspruch 8, **dadurch gekennzeichnet, dass** jeder Detektionsverstärker am Ende der Lesedauer anhand des Referenzsignals (rd_mon) deaktiviert wird, wobei das Referenzsignal während der Lesedauer, in der der parasitäre Kondensator und der Zeitgebungskondensator mittels eines von dem Referenz-Detektionsverstärker gelieferten Stroms in der Ladephase sind, von einem ersten Zustand in einen zweiten Zustand, in dem die Kondensatoren geladen sind, übergeht.

10. Verfahren nach einem der Ansprüche 8 und 9, **dadurch gekennzeichnet, dass** während der Lesedauer das Referenzsignal das Speichern gültiger Daten der ausgewählten Speicherzellen in einem Sperrregister (5) befiehlt.

11. Verfahren nach einem der Ansprüche 8 bis 10, **dadurch gekennzeichnet, dass** die Detektionsverstärker durch ein Ausgangssignal (n_en_amp) einer Logikschaltung (10, 11, 12) nach dem Übergang von dem ersten Zustand in den zweiten Zustand des an den Eingang der Logikschaltung gelieferten Referenz-signals deaktiviert werden, wobei die Logikschaltung ein Zeitverzögerungsgatter umfasst, um die Desaktivierung der Detektionsverstärker nach dem Zustandswechsel des Referenzsignals zu verzögern.
